# EUROPÄISCHE PATENTSCHRIFT

(11) **EP 2 130 214 B1**
(45) Veröffentlichungstag und Bekanntmachung des Hinweises auf die Patenterteilung: **02.01.2013**
(21) Anmeldenummer: 08716881.1
(22) Anmeldetag: 15.02.2008
(51) Int. Cl.: H01L 21/02, H01L 21/20, C23C 16/02, C23C 16/04, C23C 16/24, C23C 16/28

(54) **SELEKTIVES WACHSTUM VON POLYKRISTALLINEM SILIZIUMHALTIGEN HALBLEITERMATERIAL AUF SILIZIUMHALTIGER HALBLEITEROBERFLÄCHE**
SELECTIVE GROWTH OF POLYCRYSTALLINE SILICON-CONTAINING SEMICONDUCTOR MATERIAL ON A SILICON-CONTAINING SEMICONDUCTOR SURFACE
CROISSANCE SÉLECTIVE DE MATÉRIAU SEMI-CONDUCTEUR POLYCRISTALLIN À BASE DE SILICIUM SUR UNE SURFACE SEMI-CONDUCTRICE CONTENANT DU SILICIUM

(30) Priorität: 22.02.2007 DE 102007010563
(43) Veröffentlichungstag der Anmeldung: 09.12.2009
(73) Patentinhaber: IHP GmbH-Innovations for High Performance Microelectronics / Leibniz-Institut für innovative Mikroelektronik, 15236 Frankfurt / Oder (DE)
(72) Erfinder: TILLACK, Bernd, 15234 Frankfurt (DE); HEINEMANN, Bernd, 15234 Frankfurt (DE); YAMAMOTO, Yuji, 15232 Frankfurt (DE)
(74) Vertreter: Eisenführ, Speiser & Partner
(86) Internationale Anmeldenummer: PCT/EP2008/051875
(87) Internationale Veröffentlichungsnummer: WO 2008/101877

(56) Entgegenhaltungen:
- WO-A-2008/015211
- US-A1- 2006 172 501

## Beschreibung

Die Erfindung betrifft ein Verfahren zur Abscheidung von polykristallinem siliziumhaltigen Halbleitermaterial ausschließlich auf einkristallinen ersten siliziumhaltigen Halbleiteroberflächenabschnitten einer Substratoberfläche, die zusätzlich Isolatoroberflächenabschnitte aufweist.

Eine Abscheidung von polykristallinem Silizium auf einkristallinen Siliziumoberflächenabschnitten einer Substratoberfläche gelingt derzeit nur, wenn die einkristallinen Siliziumoberflächenabschnitte mit einer dünnen Siliziumdioxidschicht bedeckt sind. Für viele Bauelementanwendungen ist jedoch die Gegenwart einer Oxidschicht zwischen einkristallinem Silizium und polykristallinem Silizium störend.

US 2006/172 501 offenbart ein Verfahren zur Abscheidung von polykristallinem siliziumhaltigen Halbleitermaterial auf mit Bor implantierten Oberflächenbereichen eines Substrats.

Das Problem besteht entsprechend auch für die Abscheidung von Siliziumgermanium, oder kohlenstoffdotiertem Silizium oder Siliziumgermanium. Es tritt nicht im Zusammenhang mit Siliziumoberflächen auf, sondern auch bei Oberflächen aus Siliziumgermanium oder kohlenstoffdotiertem Silizium oder Siliziumgermanium.

Das der Erfindung zugrunde liegende technische Problem ist es daher, ein Verfahren anzugeben, mit dem polykristallines siliziumhaltiges Halbleitermaterial direkt auf einkristallinen siliziumhaltigen Halbleiteroberflächenabschnitten einer Substratoberfläche abgeschieden werden kann.

Das technische Problem wird gelöst durch ein Verfahren zur Abscheidung von polykristallinem siliziumhaltigen Halbleitermaterial ausschließlich auf einkristallinen ersten siliziumhaltigen Halbleiteroberflächenabschnitten, nachfolgend als erste Oberflächenabschnitte bezeichnet, einer Substratoberfläche, die neben den ersten Oberflächenabschnitten zusätzlich Isolatoroberflächenabschnitte aufweist, mit den Schritten:
- Abscheiden von Bor auf den ersten Oberflächenabschnitten in einer Menge, die bezogen auf die ersten Oberflächenabschnitte jeweils mehr als einer Monolage Bor entspricht;
- Abscheiden von siliziumhaltigem Halbleitermaterial auf den so behandelten ersten Oberflächenabschnitten.

Mit dem erfindungsgemäßen Verfahren gelingt es, polykristallines siliziumhaltiges Halbleitermaterial, beispielsweise Silizium oder Siliziumgermanium, selektiv auf den einkristallinen ersten Oberflächenabschnitten der Substratoberfläche abzuscheiden. "Selektiv" bedeutet in diesem Zusammenhang, dass eine Abscheidung ausschließlich auf den einkristallinen ersten Oberflächenabschnitten erfolgt und nicht auf den Isolatoroberflächenabschnitten der Substratoberfläche.

Das Verfahren beruht auf der Erkenntnis, dass durch das Abscheiden von Bor auf den ersten Oberflächenabschnitten in einer Menge, die bezogen auf die ersten Oberflächenabschnitte jeweils mehr als einer Monolage Bor entspricht, eine für das Wachstum von polykristallinem siliziumhaltigen Halbleitermaterial geeignete Substratoberfläche geschaffen wird. Die Bor-Abscheidung bedeckt die einkristallinen ersten Oberflächenabschnitte, so dass die Gitterstruktur der Oberflächenabschnitte beim nachfolgenden Abscheiden von siliziumhaltigem Halbleitermaterial auf der Bor-Abscheidung die Struktur des aufwachsenden Siliziums nicht mehr prägen kann. Es erfolgt daher ein nicht-epitaktisches Wachstum von polykristallinem siliziumhaltigem Halbleitermaterial.

Das erfindungsgemäße Verfahren ermöglicht eine Auswahl der Oberflächenabschnitte, auf denen polykristallines siliziumhaltiges Halbleitermaterial abgeschieden werden soll. Es erhöht damit die Flexibilität bei der Gestaltung der Schichtstrukturen von Halbleiterbauelementen mit siliziumhaltigen Halbleiterschichten. Hierzu wird weiter unten ein konkretes Ausführungsbeispiel beschrieben.

Nach den Erkenntnissen der Erfinder führt das Abscheiden von Bor in einer Menge, die bezogen auf die ersten Oberflächenabschnitte jeweils weniger als einer Monolage Bor entspricht, nicht zu polykristallinem, sondern zu epitaktischem Wachstum.

Wie oben erläutert, wird der Begriff "erste Oberflächenabschnitte" hier für siliziumhaltige Halbleiteroberflächenabschnitte verwendet. Es handelt sich also um Abschnitte der Substratoberfläche, die von einem siliziumhaltigen Halbleitermaterial gebildet sind. Auch können die ersten Oberflächenabschnitte kohlenstoffdotiert sein. Der Kohlenstoffanteil kann hierbei zwischen Werten einer unabsichtlichen Hintergrunddotierung und einigen Prozent, also im Bereich bis einigen 10²² cm⁻³ liegen. Siliziumcarbid soll für die Zwecke dieser Anmeldung nicht unter den Begriff "siliziumhaltiges Halbleitermaterial" fallen.

Andere Dotierstoffe wie Sauerstoff oder Dotierstoffe zur Erzielung einer gewünschten Leitfähigkeit wie etwa Phosphor, Arsen, Bor oder Aluminium können in üblichen Konzentrationen enthalten sein, wobei jedoch weder die siliziumhaltigen Halbleiteroberflächenabschnitte noch das abgeschiedene Material eine Entartung (metallische Leitfähigkeit) aufweisen.

Das Halbleitermaterial ist beispielsweise Silizium oder Siliziumgermanium, mit oder ohne Kohlenstoffdotierung. Der Germaniumanteil beträgt typischerweise bis 20%, kann jedoch auch darüber liegen. Das erfindungsgemäße Verfahren kann in einem besonderen Ausführungsbeispiel sogar für die Abscheidung von Germanium auf einer Germanium- oder Siliziumgermaniumoberfläche angewendet werden. Man könnte daher alternativ in der Beschreibung des erfindungsgemäßen Verfahrens für das abgeschiedene Halbleitermaterial wie für das Material der damit zu bedeckenden Substratoberfläche den Begriff "Silizium- und/oder Germanium enthaltendes Halbleitermaterial" verwenden, der Silizium, Siliziumgermanium und Germanium jeweils mit oder ohne Kohlenstoffdotierung umfasst, Siliziumcarbid jedoch ausschließen soll.

Nachfolgend werden Ausführungsbeispiele des erfindungsgemäßen Verfahrens beschrieben. Die Ausführungsbeispiele können miteinander kombiniert werden, wenn Sie nicht ausdrücklich als Alternativen zueinander beschrieben sind.

Es ist nicht erforderlich und in der obigen Beschreibung der Verfahrensführung nicht als notwendige Bedingung zu verstehen, dass Bor ausschließlich auf den ersten Oberflächenabschnitten abgeschieden wird. Bor wird in einem Ausführungsbeispiel unmaskiert auf der Substratoberfläche abgeschieden, was die ersten Siliziumobertlächenabschnitte und die Isolatoroberflächenabschnitte einschließt. Anschließend wird in diesem Ausführungsbeispiel Silizium oder Siliziumgermanium abgeschieden, was zur selektiven Bildung einer polykristallinen Schicht dieses Materials auf den ersten Oberflächenabschnitten führt. Auf den Isolatoroberflächenabschnitten findet bei diesem Ausführungsbeispiel keine Abscheidung statt. Alternativ kann auch eine maskierte Abscheidung von Bor ausschließlich auf den ersten Siliziumoberflächenabschnitten vorgenommen werden, was jedoch aufwändiger ist.

Bei einem Ausführungsbeispiel wird der Schritt des Abscheidens von siliziumhaltigem Halbleitermaterial unter Abscheidebedingungen einer epitaktischen Abscheidung durchgeführt durchgeführt. Dieses Verfahren ermöglicht in einer Fortbildung das gleichzeitige Abscheiden von polykristallinem und einkristallinem Halbleitermaterial. Ein solches Verfahren, bei dem die Substratoberfläche zusätzlich zweite siliziumhaltige Halbleiteroberflächenabschnitte, kurz als "zweite Oberflächenabschnitte" bezeichnet, für die einkristalline Abscheidung enthält, kann beispielsweise die folgenden zusätzlichen Schritte aufweisen:
- Bedecken der zweiten Oberflächenabschnitte mit einer Maske vor dem Abscheiden von Bor auf den ersten Oberflächenabschnitten;
- Abscheiden einer polykristallinen Silizium-Ankeimschicht auf den ersten Oberflächenabschnitten;
- Entfernen der Maske von den zweiten Oberflächenabschnitten;
- gleichzeitiges Abscheiden des polykristallinen siliziumhaltigen Halbleitermaterials auf den ersten und von epitaktischem Silizium auf den zweiten Oberflächenabschnitten.

Das Abscheiden einer polykristallinen Silizium-Ankeimschicht auf den ersten Oberflächenabschnitten nutzt die vorteilhafte Wirkung der Borabscheidung in diesem Ausführungsbeispiel in Gegenwart einer Maske. Auf der Silizium-Ankeimschicht kann im späteren Abscheideschicht dann selektiv polykristallines Silizium wachsen, wie es durch die Struktur der Silizium-Ankeimschicht vorgegeben ist. Die Silizium-Ankeimschicht ist typischerweise einige Monolagen dick. Die Silizium-Ankeimschicht verhindert auch, dass bei der Entfernung der Maske auch das abgeschiedene Bor an den ersten Siliziumoberflächenabschnitten entfernt wird, die für eine polykristalline Abscheidung vorgesehen sind.

Das Verfahren dieses Ausführungsbeispiels kann auch mit einer Ankeimschicht aus Siliziumgermanium oder kohlenstoffdotiertem Silizium oder Siliziumgermanium durchgeführt werden.

Zur näheren Erläuterung des Begriffs "zweiter Oberflächenabschnitt" kann auf die obige Erläuterung des Begriffs "erster Oberflächenabschnitt" verwiesen werden. Das dort für den "ersten Oberflächenabschnitt" Gesagte gilt hier entsprechend für den "zweiten Oberflächenabschnitt".

Bei einem weiteren Ausführungsbeispiel wird Bor in einer Menge abgeschieden, die bezogen auf die ersten Oberflächenabschnitte jeweils mehr als zwei Monolagen Bor entspricht. Beispielsweise kann die Bor-Menge 3, 7 oder mehr Monolagen Bor entsprechen. Die Bor-Menge kann hierbei so gewählt werden, wie es eine gewünschte Bor-Konzentration im fertiggestellten Bauelement erfordert. Zur Herstellung einer gewünschten Bor-Konzentration in der abgeschiedenen polykristallinen Schicht und der darunter liegenden einkristallinen Schicht wird in einem Ausführungsbeispiel ein Bor-Diffusionsschritt nach dem Abscheiden von siliziumhaltigem Halbleitermaterial durchgeführt.

Ein besonders vorteilhafter Anwendungsfall des Verfahrens der vorliegenden Erfindung betrifft die Herstellung eines teilweise polykristallinen Emitters in pnp-Heterobipolartransistoren. Bei solchen pnp-Heterobipolartransistoren ist es einerseits vorteilhaft, einen an die Basis angrenzenden Emitterabschnitt epitaktisch, also einkristallin abzuscheiden. Mit dem epitaktischen Emitterabschnitt werden besonders günstige elektrische Parameter des Heterobipolartransistors wie Emitterwiderstand und Basisstrom erzielt. Andererseits ist ein polykristalliner Emitterabschnitt in Richtung des Emitterkontaktes vorteilhaft, weil damit in diesem Abschnitt sehr hohe Dotantenkonzentrationen (>10²⁰cm⁻³) ohne schädliche Auswirkungen auf die darunter liegenden Konzentrationsprofile eingebracht werden können. Auf diese Weise wird der elektrische Kontakt zwischen dem Emitter und dem typischerweise Metallsilizid enthaltenden Emitterkontaktbereich verbessert. Das erfindungsgemäße Verfahren kann in diesem Anwendungsbeispiel also während des Wachstums des Emitters eingesetzt werden. Nach dem Abscheiden eines einkristallinen Emitterabschnitts wird das Wachstum unterbrochen. Die Wachstumsoberfläche der einkristallinen Emitterabschnitte bildet die ersten Oberflächenabschnitte im Sinne des erfindungsgemäßen Verfahrens. Diese werden dann gemäß der erfindungsgemäßen Verfahrensführung mit einer Bor-Abscheidung beaufschlagt, woraufhin Silizium abgeschieden wird, das dann polykristallin aufwächst. Vorteilhafterweise wird das abgeschiedene polykristalline Silizium in einem nachfolgenden Verfahrensschritt zur Herstellung einer Metallsilizidschicht verwendet. Das abgeschiedene polykristalline siliziumhaltige Halbleitermaterial wird also entweder ganz oder teilweise silizidiert. Geeignet ist beispielsweise eine Nickelsilizidschicht.

Die Isolatoroberflächenabschnitte können in unterschiedlichen Ausführungsbeispielen Siliziumdioxid oder Siliziumnitrid enthalten.

Die Abscheidung von Bor auf den ersten Oberflächenabschnitten erfolgt vorzugsweise mittels der an sich bekannten Atomlagenabscheidung, die gleichbedeutend auch als Atomarschichtabscheidung (engl.: Atomic Layer Deposition, ALD) bezeichnet wird. Die Atomlagenabscheidung ist weiterhin auch unter dem Namen Atomlagenepitaxie (engl.: Atomic Layer Epitaxy, ALE) bekannt. Bekanntermaßen handelt es sich bei der Atomlagenabscheidung um ein verändertes CVD-Verfahren (engl.: Chemical Vapor Deposition). Die Anzahl der abgeschiedenen Monolagen kann bei diesem Verfahren mit besonders großer Genauigkeit gesteuert werden.

Bevorzugt erfolgt die Abscheidung von Bor bei diesem Verfahren mit Hilfe eines Gasstroms von B₂H₆ als Precursor. Als Trägergas wird hierbei vorzugsweise Wasserstoff verwendet. Es hat sich als besonders günstig erwiesen, die Abscheidung von Bor nach diesem Verfahren bei einer Temperatur von 400 °C vorzunehmen. Jedoch kann dieser Temperaturbereich durchaus variiert werden.

Die anschließende Abscheidung von Silizium wird in einem Ausführungsbeispiel unter Verwendung von Dichlorsilan (DCS) als Precursor durchgeführt. Geeignet ist auch hier ein Wasserstoff-Trägergas. Die Abscheidung erfolgt vorzugsweise bei einer Temperatur von 700 °C. Es sind jedoch auch deutlich geringere Abscheidetemperaturen verwendbar.

Für die Abscheidung von Sililiziumgermanium kann als Germaniumprecursor beispielsweise German (engl. Germane, GeH₄) oder Germaniumtetrachlorid (GeCl₄). German hat den Vorteil, dass es wie Dichlorsilan bei 700 °C aktiviert werden kann, so dass das thermische Budget dieses Prozessschrittes im Vergleich mit der Verwendung von Germaniumtetrachlorid gering gehalten werden kann.

Nachfolgend wird die Erfindung unter Bezugnahme auf die Figuren anhand von Ausführungsbeispielen näher erläutert.

Es zeigen:
- Fig. 1: ein Flussdiagramm eines Ausführungsbeispiels des erfindungsgemäßen Verfahrens;
- Fig. 2-4: zeigen schematische Querschnittsansichten eines Siliziumsubstrats während unterschiedlicher Stadien der selektiven Abscheidung von polykristallinem Silizium auf einer Siliziumoberfläche;
- Fig. 5: eine rasterelektronenmikroskopische Aufnahme einer abgeschiedenen Siliziumschicht nach vorheriger Abscheidung von 0,5 Monolagen Bor;
- Fig. 6: eine rasterelektronenmikroskopische Aufnahme einer abgeschiedenen Siliziumschicht nach vorheriger Abscheidung von 3 Monolagen Bor; und
- Fig. 7: eine rasterelektronenmikroskopische Aufnahme einer abgeschiedenen Siliziumschicht nach vorheriger Abscheidung von 7 Monolagen Bor.

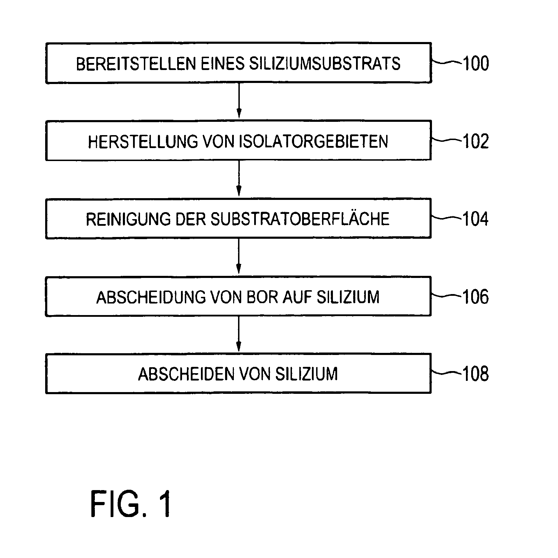

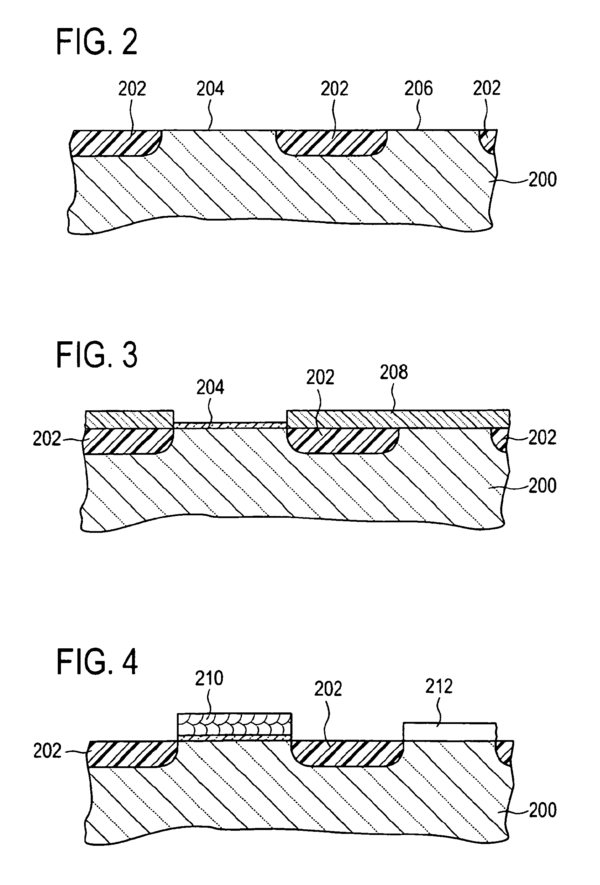

Figur 1 zeigt ein Flussdiagramm eines Ausführungsbeispiels des erfindungsgemäßen Verfahrens. Die Figur 1 wird nachfolgend parallel mit den Figuren 2 bis 4 beschrieben. Die Figuren 2 bis 4 zeigen schematische Querschnittsansichten eines Siliziumsubstrats 200 während unterschiedlicher Stadien der selektiven Abscheidung von polykristallinem Silizium auf einer Siliziumoberfläche.

Das Verfahren beginnt in einem Schritt 100 mit dem Bereitstellen eines Siliziumsubstrats. Das Siliziumsubstrat hat eine einkristalline Siliziumoberfläche. Das Siliziumsubstrat kann beispielsweise in Form eines Wafers mit einer (001) Siliziumoberfläche vorliegen. Für die Zwecke der vorliegenden Beschreibung wird angenommen, dass es sich beim Substrat 200 um einen solchen Wafer handelt. Das Siliziumsubstrat kann jedoch auch durch einen Wafer in einem späteren Stadium der Herstellung von integrierten Schaltkreisen gebildet sein. Beispielsweise kann der Wafer bereits funktionelle Schichten von pnp-Heterobipolartransistoren enthalten. Insbesondere eine epitaktische Basisschicht und einen darauf abgeschiedenen epitaktischen, also einkristallinen Emitter-Schichtabschnitt. Auch funktionelle Schichten von MOS- oder CMOS-Transistoren können alternativ oder zusätzlich bereits vorhanden sein.

Bei dem vorliegend beschriebenen einfachen Ausführungsbeispiel werden jedoch zunächst in einem Schritt 102 Isolatorgebiete 202 hergestellt. Diese trennen unterschiedliche Siliziumoberflächenabschnitte voneinander. Im vorliegenden Beispiel sind ein einkristalliner erster Siliziumoberflächenabschnitt 204 und ein einkristalliner zweiter Siliziumoberflächenabschnitt 206 vorhanden. Die Substratoberfläche wird anschließend in einem Schritt 104 gereinigt, bevor in einem maskierten Abscheideschritt Bor in einer Menge von mehr als einer Monolage im ersten Siliziumoberflächenabschnitt 204 abgeschieden wird (Schritt 106). Die Abscheidung von Bor erfolgt beispielsweise mittels mit Atomlagenabscheidung bei einer Temperatur von 400 °C. In einem Ausführungsbeispiel wird als Bor-Precursor B₂H₆ in einer Menge von 160 sccm entsprechend einer Menge von 250 ppm in einem Wasserstoff-Trägergas verwendet. Das Wasserstoff-Trägergas wird mit 20 SLM bei einem DrucK von 107 hPa (80 Torr) bereitgestellt. Nach der Borbelegung wird eine polykristalline Si-Ankeimschicht abgeschieden. Diese polykristalline Si-Schicht kann auch als Keimschicht für polykristallines Wachstum dienen, wenn nach Entfernung der Maske 208 auf einem zweiten Siliziumoberflächenabschnitt 206 Si epitaktisch gewachsen wird.

Eine Maske 208 dient hierbei der Abdeckung des zweiten Siliziumoberflächenabschnitts 206. Auf diesem soll nachfolgend keine polykristalline Siliziumschicht abgeschieden werden. Denkbar ist auch, dass der zweite Siliziumoberflächenabschnitt 206 mit einer n-dotierten Siliziumschicht bedeckt werden soll.

Nachfolgend wird auf der von der Maske 208 befreiten Substratoberfläche Silizium abgeschieden (Schritt 108). Im ersten Siliziumoberflächenabschnitt erfolgt die Abscheidung also auf der polykristallinen Si-Ankeimschicht. Die Abscheidung von Silizium erfolgt in einem Ausführungsbeispiel bei einer Temperatur von 700 °C mit DCS als Precursor. Eine Menge von 50 sccm bei Wasserstoffträgergas von 20 SLM unter einem Druck von 107 hPa (80 Torr)sind beispielsweise geeignet.

Diese Bedingungen sind geeignet, um auf der Ankeimschicht im ersten Siliziumoberflächenabschnitt eine polykristalline Siliziumschicht 210 aufwachsen zu lassen, während auf den isolationsgebieten 202 kein Silizium abgeschieden wird. Zugleich wächst jedoch auf dem zweiten Siliziumoberflächenabschnitt 206 eine epitaktische, einkristalline Siliziumschicht 212 auf.

In einem nachfolgenden Schritt kann durch Tempern des Substrats 200 eine Diffusion von Bor in die benachbarten Schichten veranlasst werden. Die Diffusion kann durch Beimengung von Kohlenstoff verhindert werden, wenn dies für eine bestimmte Schicht gewünscht ist. Beispielsweise könnte das Substrat 200 durch Einbau von Kohlenstoff in oberflächennahe Schichten nahe dem ersten Siliziumoberflächenabschnitt 204 vor einer Eindiffusion von Bor weitgehend geschützt werden.

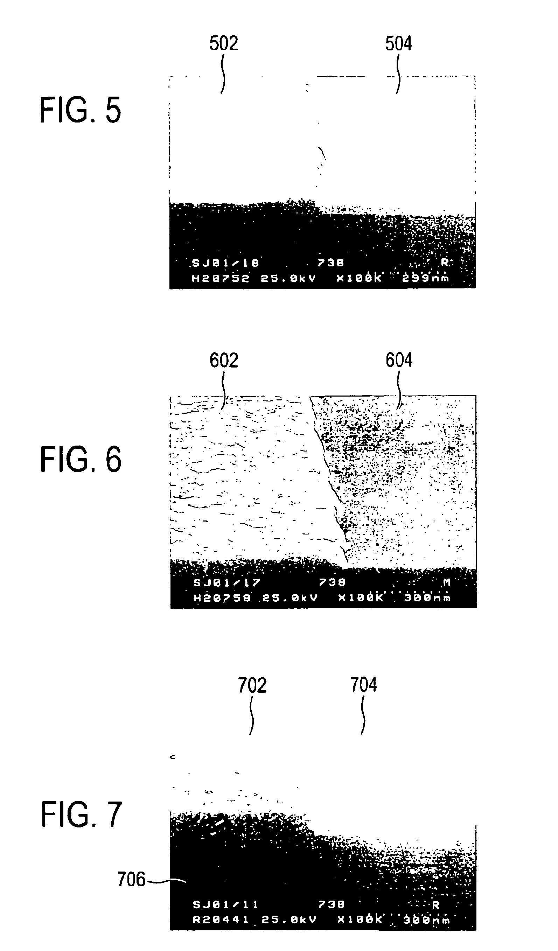

Figur 5 zeigt eine rasterelektronenmikroskopische Aufnahme einer abgeschiedenen Siliziumschicht nach vorheriger Abscheidung von 0,5 Monolagen Bor. Figur 6 zeigt eine rasterelektronenmikroskopische Aufnahme einer abgeschiedenen Siliziumschicht nach vorheriger Abscheidung von 3 Monolagen Bor. Figur 7 zeigt eine rasterelektronenmikroskopische Aufnahme einer abgeschiedenen Siliziumschicht nach vorheriger Abscheidung von 7 Monolagen Bor.

In Figur 5 ist eine rasterelektronenmikroskopische Aufnahme einer epitaktischen, im wesentlichen einkristallinen Siliziumschicht 502 neben einer Isolatorschicht 504 dargestellt. Diese Struktur wurde nicht nach einem erfindungsgemäßen Verfahren hergestellt. Denn es wurde eine Bor-Menge auf einer in Figur 5 nicht erkennbaren Siliziumoberfläche unterhalb der Siliziumschicht 502 abgeschieden, die lediglich einer halben Monolage entspricht. Unter diesen Bedingungen kann polykristallines Silizium nicht hergestellt werden.

Figur 6 zeigt dagegen, dass bei Abscheidung einer Bor-Menge entsprechend 3 Monolagen eine polykristalline Schicht 602 neben einer Isolatorschicht 604 selektiv aufgewachsen werden kann. Die polykristalline Struktur der Siliziumschicht 602 ist deutlich an ihrer Oberflächenrauhigkeit im Vergleich mit der epitaktischen Siliziumschicht 502 erkennbar. Die epitaktische Schicht 502 der Figur 5 zeigt so gut wie keinen Oberflächenkontrast, während dieser bei der Schicht 602 stark ausgeprägt ist.

Figur 7 zeigt ein der Figur 6 entsprechendes Ergebnis nach Verwendung von 7 Monolagen Bor vor selektiver Abscheidung einer polykristallinen Siliziumschicht 702 auf dem mit Bor belegten Siliziumsubstrat 706. Auch hier wird auf einer benachbarten Isolatorschicht 704 kein Silizium abgeschieden.

Das vorstehend beschriebene Verfahren ermöglicht also eine Abscheidung von polykristallinem Silizium auf einkristallinen Siliziumoberflächenabschnitten einer Substratoberfläche. Dieses Verfahren ist für verschieden Anwendungen in der Bauelementeherstellung geeignet. Als Beispiel wurde die Herstellung eines teilweise polykristallinen Emitters für pnp-Heterobipolartransistoren beschrieben.

Die anhand der Figuren beschriebenen Ausführungsbeispiele beschränken sich zwar auf die Abscheidung von Silizium auf einer Siliziumoberfläche. Jedoch ist dies nicht einschränkend zu verstehen. Wie weiter oben ausführlich erläutert wurde, ist das erfindungsgemäße Verfahren für verschiedene abzuscheidende siliziumhaltige Materialien anwendbar und können hierfür nicht nur Siliziumoberflächen, sondern auch andere siliziumhaltige Halbleiteroberflächen verwendet werden.

## Patentansprüche

1. Verfahren zur Abscheidung von polykristallinem siliziumhaltigen Halbleitermaterial ausschließlich auf einkristallinen ersten siliziumhaltigen Halbleiteroberflächenabschnitten, nachfolgend als erste Oberflächenabschnitte bezeichnet, einer Substratoberfläche, die neben den ersten Oberflächenabschnitten zusätzlich isolatoroberflächenabschnitte aufweist, mit den Schritten:
- Abscheiden von Bor auf den ersten Oberflächenabschnitten in einer Menge, die bezogen auf die ersten Oberflächenabschnitte jeweils mehr als einer Monolage Bor entspricht;
- Abscheiden von siliziumhaltigem Halbleitermaterial auf den so behandelten ersten Oberflächenabschnitten.

2. Verfahren nach Anspruch 1, bei dem das Abscheiden von Bor unmaskiert auf der Substratoberfläche erfolgt, einschließlich der ersten Oberflächenabschnitte und der isolatoroberflächenabschnitte.

3. Verfahren nach Anspruch 1 oder 2, bei dem der Schritt des Abscheidens von siliziumhaltigem Halbleitermaterial unter Abscheidebedingungen einer epitaktischen Abscheidung durchgeführt wird.

4. Verfahren nach Anspruch 3, bei dem die Substratoberfläche zusätzlich zweite siliziumhaltige Halbleiteroberflächenabschnitte enthält, nachfolgend als zweite Oberflächenabschnitte bezeichnet, mit den zusätzlichen Schritten:
- Bedecken der zweiten Oberflächenabschnitte mit einer Maske vor dem Abscheiden von Bor auf den ersten Oberflächenabschnitten;
- Abscheiden einer polykristallinen Silizium-Ankeimschicht auf den ersten Oberflächenabschnitten;
- Entfernen der Maske von den zweiten Oberflächenabschnitten;
- gleichzeitiges Abscheiden des polykristallinen siliziumhaltigen Halbleitermaterials auf den ersten und von epitaktischem Silizium auf den zweiten Oberflächenabschnitten.

5. Verfahren nach einem der vorstehenden Ansprüche, welches das Abscheiden von Bor in einer Menge beinhaltet, die bezogen auf die ersten Oberflächenabschnitte jeweils mehr als zwei Monolagen Bor entspricht.

6. Verfahren nach einem der vorstehenden Ansprüche, mit einem ein Bor-Diffusionsschritt nach dem Schritt des Abscheidens von Silizium.

7. Verfahren nach einem der vorstehenden Ansprüche, bei dem die ersten Oberflächenabschnitte einkristalline Oberflächenabschnitte eines Emitters eines pnp-Heterobipolartransistors bilden.

8. Verfahren nach Anspruch 7, bei dem nach dem Abscheiden von Silizium das abgeschiedene polykristalline siliziumhaltige Halbleitermaterial entweder ganz oder teilweise silizidiert wird.

9. Verfahren nach einem der vorstehenden Ansprüche, bei dem die Isolatoroberflächenabschnitte Siliziumdioxid oder Siliziumnitrid enthalten.

10. Verfahren nach einem der vorstehenden Ansprüche, bei dem Bor mittels Atomlagenabscheidung abgeschieden wird.

11. Verfahren nach Anspruch 10, bei dem Bor mit Hilfe eines Gasstroms von B₂H₆ in Wasserstoff-Trägergas bei einer Temperatur von 400 °C abgeschieden wird.

12. Verfahren nach einem der vorstehenden Ansprüche, bei dem das siliziumhaltige Halbleitermaterial unter Verwendung von Dichlorsilan als Siliziumprecursor in einem Wasserstoff-Trägergas bei einer Temperatur von 700 °C abgeschieden wird.

13. Verfahren nach einem der vorstehenden Ansprüche, bei dem das siliziumhaltige Halbleitermaterial entweder Silizium oder Silizium-Germanium, jeweils entweder mit oder ohne Kohlenstoffdotierung ist.

14. Verfahren nach Anspruch 1 oder 2, bei dem die ersten und gegebenenfalls zweiten Halbleiteroberflächenabschnitte jeweils aus entweder Silizium oder Silizium-Germanium gebildet sind, jeweils entweder mit oder ohne Kohlenstoffdotierung.

## Claims

1. Method of depositing polycrystalline silicon-containing semiconductor material exclusively on monocrystalline first silicon-containing semiconductor surface portions, hereinafter referred to as first surface portions, of a substrate surface which, as well as the first surface portions, additionally comprises insulator surface portions, comprising the steps of:
- depositing boron on the first surface portions in an amount that corresponds, in relation to the first surface portions, to more than a monolayer of boron;
- depositing silicon-containing semiconductor material on the first surface portions thus treated.

2. Method according to claim 1, wherein boron is deposited without a mask on the substrate surface, including the first surface portions and the insulator surface portions.

3. Method according to claim 1 or 2, wherein the step of depositing silicon-containing semiconductor material is carried out under the deposition conditions of an epitaxial deposition.

4. Method according to claim 3, wherein the substrate surface additionally contains second silicon-containing semiconductor surface portions, hereinafter referred to as second surface portions, comprising the additional steps of:
- covering the second surface portions with a mask before depositing boron on the first surface portions;
- depositing a polycrystalline silicon nucleation layer on the first surface portions;
- removing the mask from the second surface portions;
- simultaneously depositing the polycrystalline silicon-containing semiconductor material on the first surface portions and epitaxial silicon on the second surface portions.

5. Method according to one of the preceding claims, which comprises depositing boron in an amount that corresponds, in relation to the first surface portions, to more than two monolayers of boron.

6. Method according to one of the preceding claims, having a boron diffusion step after the step of precipitating silicon.

7. Method according to one of the preceding claims, wherein the first surface portions form monocrystalline surface portions of an emitter of a pnp heterobipolar transistor.

8. Method according to claim 7, wherein after the deposition of silicon the polycrystalline silicon-containing semiconductor material deposited is either totally or partially silicidated.

9. Method according to one of the preceding claims, wherein the insulator surface portions contain silicon dioxide or silicon nitride.

10. Method according to one of the preceding claims, wherein boron is deposited by atomic layer deposition.

11. Method according to claim 10, wherein boron is deposited by means of a gas current of B₂H₆ in hydrogen carrier gas at a temperature of 400°C.

12. Method according to one of the preceding claims, wherein the silicon-containing semiconductor material is deposited using dichlorosilane as silicon precursor in a hydrogen carrier gas at a temperature of 700°C.

13. Method according to one of the preceding claims, wherein the silicon-containing semiconductor material is either silicon or silicon-germanium, either with or without carbon doping.

14. Method according to claim 1 or 2, wherein the first and optional second semiconductor surface portions are each formed from either silicon or silicon-germanium, each either with or without carbon doping.

## Revendications

1. Procédé pour déposer un matériau semi-conducteur polycristallin contenant du silicium exclusivement sur des premiers tronçons de surface monocristallins contenant du silicium, désignés ci-après comme premiers tronçons de surface, d'une surface de substrat qui comporte à côté des premiers tronçons de surface en plus des tronçons de surface d'isolateur, comprenant les étapes de :
dépôt de bore sur les premiers tronçons de surface en une quantité qui, rapportée aux premiers tronçons de surface, correspond respectivement à plus d'une monocouche de bore;
dépôt de matériau semi-conducteur contenant du silicium sur les tronçons de surface ainsi traités.

2. Procédé selon la revendication 1, dans lequel le dépôt de bore s'effectue non masqué sur la surface du substrat, y compris les premiers tronçons de surface et les tronçons de surface d'isolateur.

3. Procédé selon la revendication 1 ou 2, dans lequel l'étape du dépôt de matériau semi-conducteur contenant du silicium est effectuée sous les conditions de dépôt par épitaxie.

4. Procédé selon la revendication 3, dans lequel la surface du substrat contient en plus des deuxièmes tronçons de surface de semi-conducteur contenant du silicium, désignés ci-après comme deuxièmes tronçons de surface, avec les étapes supplémentaires :
recouvrement des deuxièmes tronçons de surface par un masque avant le dépôt de bore sur les premiers tronçons de surface ;
dépôt d'une couche de germination de silicium polycristallin sur les premiers tronçons de surface ;
retrait du masque depuis les deuxièmes tronçons de surface ;
dépôt simultané du matériau semi-conducteur polycristallin contenant du silicium sur les premiers tronçons de surface et du silicium par épitaxie sur les deuxièmes tronçons de surface.

5. Procédé selon l'une quelconque des revendications précédentes, qui comprend le dépôt du bore en une quantité qui, rapportée aux premiers tronçons de surface, correspond respectivement à plus de deux monocouches de bore.

6. Procédé selon l'une quelconque des revendications précédentes, comportant une étape de diffusion du bore après l'étape de dépôt du silicium.

7. Procédé selon l'une quelconque des revendications précédentes, dans lequel les premiers tronçons de surface forment des tronçons de surface monocristallins d'un émetteur d'un transistor hétérobipolaire pnp.

8. Procédé selon la revendication 7, dans lequel, après le dépôt du silicium, le matériau semi-conducteur polycristallin contenant du silicium est soit complètement soit partiellement siliciuré.

9. Procédé selon l'une quelconque des revendications précédentes, dans lequel les tronçons de surface d'isolateur contiennent du dioxyde de silicium ou du nitrure de silicium.

10. Procédé selon l'une quelconque des revendications précédentes, dans lequel le bore est déposé par dépôt de couches atomiques.

11. Procédé selon la revendication 10, dans lequel le bore est déposé à l'aide d'un courant de gaz B₂H₆ dans de l'hydrogène comme gaz porteur à une température de 400 °C.

12. Procédé selon l'une quelconque des revendications précédentes, dans lequel le matériau semi-conducteur contenant du silicium est déposé moyennant l'utilisation de dichlorosilane comme précurseur du silicium dans de l'hydrogène comme gaz porteur à une température de 700 °C.

13. Procédé selon l'une quelconque des revendications précédentes, dans lequel le matériau semi-conducteur contenant du silicium est soit du silicium, soit du silicium-germanium, respectivement soit avec, soit sans dopage de carbone.

14. Procédé selon la revendication 1 ou 2, dans lequel les premiers et le cas échéant les deuxièmes tronçons de surface de semi-conducteur sont formés soit de silicium, soit de silicium-germanium, respectivement soit avec, soit sans dopage de carbone.
